# EUROPÄISCHE PATENTSCHRIFT

(11) **EP 1 509 996 B1**
(45) Veröffentlichungstag und Bekanntmachung des Hinweises auf die Patenterteilung: **07.07.2010**
(21) Anmeldenummer: 03732897.8
(22) Anmeldetag: 19.05.2003
(51) Int. Cl.: H03C 1/54, H03D 7/14

(54) **AUFWÄRTS-FREQUENZUMSETZER**
STEP-UP FREQUENCY CONVERTER
CONVERTISSEUR DE FREQUENCE VERS LE HAUT

(30) Priorität: 17.05.2002 DE 10222622
(43) Veröffentlichungstag der Anmeldung: 02.03.2005
(73) Patentinhaber: Ericsson AB, 164 80 Stockholm (SE)
(72) Erfinder: GILL, Hardial, Singh, 71522 Backnang (DE); KRUPA, Richard, 71540 Murrhardt (DE); KOCH, Stefan, 71570 Oppenweiler (DE)
(74) Vertreter: Manitz, Finsterwald & Partner GbR
(86) Internationale Anmeldenummer: PCT/IB2003/002588
(87) Internationale Veröffentlichungsnummer: WO 2003/098794

(56) Entgegenhaltungen:
- US-A- 5 039 891
- US-A1- 2001 046 849
- NISHIKAWA K ET AL: "BROADBAND AND COMPACT SIBJT BALANCED UP-CONVERTER MMIC USING SI 3-D MMIC TECHNOLOGY" 2001 IEEE MTT-S INTERNATIONAL MICROWAVE SYMPOSIUM DIGEST.(IMS 2001). PHOENIX, AZ, MAY 20 - 25, 2001, IEEE MTT-S INTERNATIONAL MICROWAVE SYMPOSIUM, NEW YORK, NY: IEEE, US, Bd. 1 OF 3, 20. Mai 2001 (2001-05-20), Seiten 87-90, XP001067239 ISBN: 0-7803-6538-0 in der Anmeldung erwähnt
- BRADY V ET AL: "Development of a monolithic FET Ka-band single side band upconverter and image reject downconverter" GAAS IC SYMPOSIUM, 22. Oktober 1989 (1989-10-22), Seiten 189-192, XP010085943

## Beschreibung

Die vorliegende Erfindung betrifft einen Aufwärts-Frequenzumsetzer. Derartige Frequenzumsetzer werden in Funk-Kommunikationssystemen zum Verschieben eines mit einer Zwischenfrequenz vorliegenden Nachrichtensignals auf eine für die Funkübertragung vorgesehene Sendefrequenz benötigt. Die Wellenlängen der Funksignale können im Millimeterbereich liegen.

Der zunehmende Umfang der Integration bei Kommunikationssystemen für diese Wellenlängen führt auch zu einem gesteigerten Bedarf nach platzsparend monolithisch integrierbaren Frequenzumsetzern.

Ein Aufwärts-Frequenzumsetzer nach dem Oberbegriff des Anspruchs 1 ist aus Nishikawa et al., "Broadband and Compact SiBJT Balanced Up-Converter MMIC using Si 3-D MMIC Technology", IEEE MMT-S International Microwave Symposium 2001, Phoenix, Arizona, USA, S. 87 - 90, bekannt. Bei diesem bekannten Frequenzumsetzer liegen die zwei zu mischenden Signale, ein Zwischenfrequenzsignal und ein Lokaloszillatorsignal, jeweils im Gegentakt an den Basen von zwei Bipolartransistoren an und modulieren durch die Bipolartransistoren fließende Ströme, die additiv zum auszugebenden Hochfrequenzsignal überlagert werden. Die an die Bipolartransistoren angelegten gegenphasigen Lokaloszillatorsignale werden von einem auf dem Substrat integrierten Symmetrierglied geliefert, an dessen Eingang das Lokaloszillatorsignal in asymmetrischer Form eingespeist wird. Das Symmetriergl ied ist aufgebaut aus einer Mehrzahl von Leiterbahnabschnitten mit jeweils.. einer Länge λ/4 und belegt auf dem Substrat der integrierten Schaltung mehr Platz als alle anderen Schaltungskomponenten zusammen. Das ebenfalls in symmetrischer Form benötigte Zwischenfrequenzsignal, dessen Frequenz niedriger als die des Lokaloszillatorsignals ist, wird der Schaltung über zwei getrennte Anschlüsse von außen zugeführt. Unterschiede in den außerhalb der integrierten Schaltung liegenden Zuleitungen zu diesen zwei Anschlüssen, insbesondere unterschiedliche Längen und Dämpfungen, können zu unterschiedlichen Amplituden der anliegenden Zwischenfrequenzsignale und Abweichungen ihrer Phasendifferenz von der gewünschten exakten Gegenphasigkeit und damit zu einer Asymmetrie im Verhalten der zwei Bipolartransistoren führen. Die Qualität des Mischungsergebnisses hängt somit unter anderem von der Verdrahtung der Schaltung ab; d. h. Fertigungsstreuungen bei der Verdrahtung können die Wirksamkeit des Frequenzumsetzers beeinträchtigen.

Aus der US 2001/0046849 A1 ist ein in einem monolithisch integrierten Mikrowellenschaltkreis (MMIC) verwirklichter Abwärtsumsetzer bekannt, bei dem ein mit dem Eingangssignal niedrigerer Frequenz des Mischers verbundenes Symmetrieglied verwendet wird.

Aufgabe der vorliegenden Erfindung ist, einen integrierbaren Aufwärts-Frequenzumsetzer mit einem guten, reproduzierbaren und von Fertigungsstreuungen wenig abhängigen Umsetzverhalten zu schaffen. Die Aufgabe wird gelöst durch einen Aufwärts-Frequenzumsetzer mit den Merkmalen des Anspruchs 1. Indem ein Symmetrierglied für die niedrigere Eingangsfrequenz auf dem Substrat integriert wird, werden Länge und Dämpfung der Verbindung zwischen dem Symmetrierglied und den ersten Hauptanschlüssen der zwei Steuerelemente exakt kontrollierbar und reproduzierbar.

Vorzugsweise wird als Symmetrierglied für die niedrigere Eingangsfrequenz ein drittes Steuerelement eingesetzt, dessen Steueranschluss mit dem ersten Eingangssignal beschaltet ist und von dessen zwei Hauptanschlüssen jeder mit einem von zwei Versorgungspotentialen des Aufwärts-Frequenzumsetzers und einem Anschluss des ersten bzw. zweiten Steuerelementes verbunden ist. Ein solches Symmetrierglied erfordert sehr wenig Substratfläche im Vergleich zu einem Symmetrierglied des bei Nishikawa et al. eingesetzten Typs, dessen Platzbedarf proportional zur Wellenlänge des zu symmetrierenden Signals ist, und es weist eine große Bandbreite auf.

Vorzugsweise sind die Anschlüsse des ersten bzw. zweiten Steuerelements, mit dem die Hauptanschlüsse des dritten Steuerelementes verbunden sind, jeweils deren zweite Hauptanschlüsse. Dies erlaubt eine multiplikative Modulation des ersten Eingangssignals durch das zweite und damit eine hohe Effektivität des Mischvorgangs.

Als Steuerelemente werden vorzugsweise Transistoren, insbesondere HEMTs (High Electron Mobility Transistors) eingesetzt.

Um eine hohe Mischungseffizienz zu erreichen, sind das erste und das zweite Steuerelement vorzugsweise bis in die Nähe ihres Pinch-off-Bereiches vorgespannt.

Zweckmäßigerweise ist auch für das zweite, höher frequente Eingangssignal ein Symmetrierglied vorgesehen, das ausgangsseitig mit den Steuereingängen des ersten und des zweiten Steuerelements verbunden ist.

Gegenstand der Erfindung ist ferner ein Einseitenband-Frequenzumsetzer, der aus den oben beschriebenen Aufwärts-Frequenzumsetzern realisierbar ist, indem die Ausgänge zweier solcher Aufwärts-Frequenzumsetzer an Eingänge eines Lange-Kopplers angeschlossen sind, von dem ein Ausgang den Ausgang des Einseitenband-Frequenzumsetzers bildet.

Das zweite Symmetrierglied der Aufwärts-Frequenzumsetzer eines solchen Einseitenband-Frequenzumsetzers, zweckmäßigerweise mit einem Leistungsteiler verschmolzen, um Substratfläche einzusparen. Der Leistungsteiler verteilt das zweite Eingangssignal zu gleichen Teilen an die zwei Aufwärts-Frequenzumsetzer. Ein solches verschmolzenes oder kombiniertes Symmetrierglied ist einfach und platzsparend realisierbar mit einem mittigen, mit einem Signaleingang des Einseitenband-Frequenzumsetzers verbundenen ersten Leiterabschnitt und, beiderseits des ersten Leiterabschnitts, einer Mehrzahl von zweiten Leiterabschnitten, wobei die Steuereingänge des ersten und zweiten Steuerelements des ersten Aufwärts-Frequenzumsetzers mit zweiten Leiterabschnitten auf einer Seite des mittigen Leiterabschnitts verbunden sind und die Steuereingänge des ersten und zweiten Steuerelements des zweiten Aufwärts-Frequenzumsetzers mit zweiten Leiterabschnitten auf der anderen Seite des mittigen Leiterabschnitts verbunden sind.

Diese Leiterabschnitte sind als Mikrostreifenleiter in einer gemeinsamen Ebene einfach realisierbar.

Vorzugsweise weist das zweite Symmetrierglied je drei nebeneinanderliegende Leiterabschnitte beiderseits des mittigen Leiterabschnitts auf, von denen jeweils ein mittlerer unverbunden ist.

Weitere Merkmale und Vorteile der Erfindung ergeben sich aus der nachfolgenden Beschreibung eines Ausführungsbeispiels mit Bezug auf die beigefügten Figuren. Es zeigen:
- Fig. 1: ein schematisches Schaltbild eines erfin- dungsgemäßen Aufwärts-Frequenzumsetzers;
- Fig. 2: ein Schaltbild eines Einseitenband- Frequenzumsetzers; und
- Fig. 3: eine schematische Darstellung eines Halb- leitersubstrates, auf dem der Einseiten- band-Frequenzumsetzer aus Fig. 2 integ- riert ist.

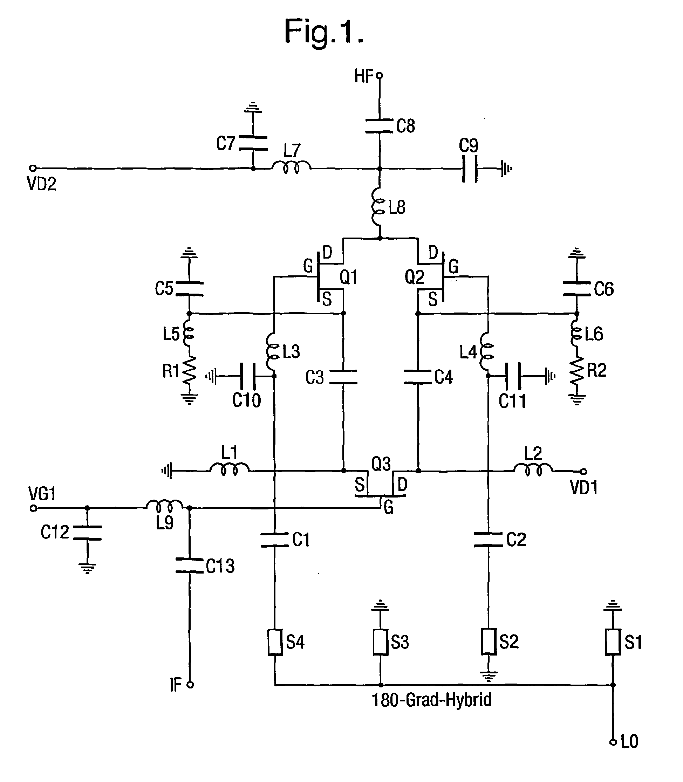

Fig. 1 zeigt ein schematisches Schaltbild eines auf einem Substrat integrierten Aufwärts-Frequenzumsetzers gemäß der vorliegenden Erfindung. Dieser umfasst als Steuerelemente zwei GaAs-HEMTs Q1 und Q2 in symmetrischer Anordnung. Die Gates der HEMTs Q1, Q2 sind mit einem Lokaloszillatorsignal LO über einen aus parallelen Streifenleitern S1 bis S4 aufgebauten 180°-Hybrid-Koppler und Kondensatoren C1, C2 im Gegentakt beschaltet. Die Drains der HEMTs Q1, Q2 sind miteinander und über zwei Induktivitäten L8, L7 mit einem Eingangsanschluss für eine Versorgungsspannung VD2 verbunden. Die Source jedes HEMT Q1, Q2 ist über einen Kondensator C3 bzw. C4 mit Source bzw. Drain eines dritten HEMT Q3 sowie über einen Kondensator C5 bzw. C6 und über eine Serienschaltung mit einer Induktivität L5 bzw. L6 und einem Widerstand R1 bzw. R2 mit Masse verbunden. Ein durch den Source-Strom des HEMT Q1 bzw. Q2 hervorgerufener Spannungsabfall am Widerstand R1, R2 bewirkt eine automatische Arbeitspunkteinstellung (self-bias) des HEMT knapp unterhalb von dessen Pinch-Off-(Abschnür-)Bereich.

Source und Drain des HEMT Q3 sind jeweils über eine Induktivität L1 bzw. L2 mit Masse GND bzw. einem Versorgungspotential VD1 verbunden. An das Gate des HEMT Q3 ist eine Vorspannung VG1 über eine Induktivität L9 und das Zwischenfrequenzsignal IF über einen Kondensator C13 angeschlossen.

Die Spannung am Gate des HEMT Q3 setzt sich somit aus einer von VG1 beigetragenen Gleichspannungskomponente und einer von IF beigetragenen Wechselspannungskomponente zusammen. Die Gleichspannungskomponente ist so gewählt, dass der HEMT Q3 im linearen Bereich arbeitet; IF moduliert weitgehend linear den Drain-Strom des HEMT Q3. Die Potentiale an Drain und Source des HEMT Q3 oszillieren somit gegenphasig zueinander mit einer größeren Amplitude als der des IF-Signals.

Der HEMT Q3 wirkt somit gleichzeitig als Verstärker und als Symmetrierglied für das Zwischenfrequenzsignal IF. Im allgemeinen wird man gleiche Werte der Induktivitäten L1, L2 wählen, um gleiche Amplituden des Zwischenfrequenzsignals an Source und Drain des HEMT Q3 zu erzielen.

Die Stromflüsse durch die zwei HEMTs Q1, Q2, an deren Drain jeweils über die Induktivitäten L8, L7 die Versorgungsspannung VD2 anliegt, setzen sich jeweils hauptsächlich zusammen aus einem Anteil mit der Frequenz des Lokaloszillatorsignals LO, einem Anteil mit der Frequenz des Zwischenfrequenzsignals IF und Anteilen bei der Summe und der Differenz der Frequenzen von Lokaloszillatorsignal LO und Zwischenfrequenzsignal IF. Da die Gates der HEMTs Q1, Q2 gegenphasig mit dem Lokaloszillatorsignal LO beschaltet sind, sind die Anteile dieser Stromflüsse mit der Lokaloszillatorfrequenz jeweils entgegengesetzt gleich und heben einander auf. Ebenso sind die Zwischenfrequenz-Anteile jeweils entgegengesetzt gleich und heben einander auf. Der durch die Induktivität L3 fließende Strom und damit das Potential am Verbindungspunkt zwischen den Induktivitäten L7, L8 enthält somit nur Spektralanteile mit der Summen- bzw. Differenzfrequenz. Diese Anteile werden über einen Kondensator C8 an den Ausgang HF ausgekoppelt und ergeben das Ausgangssignal des Aufwärts-Frequenzumsetzers, ein trägerloses Hochfrequenzsignal mit zwei jeweils durch den Summen- bzw. Differenzfrequenzanteil gebildeten Seitenbändern.

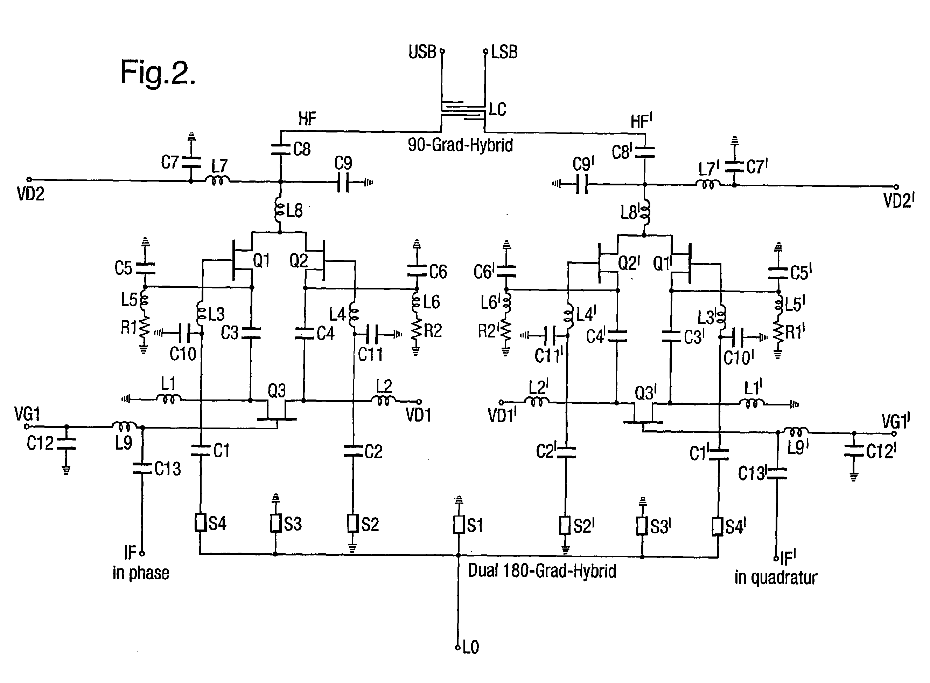

Fig. 2 zeigt einen Einseitenband-Umsetzer, der aus zwei Aufwärts-Umsetzern vom in Fig. 1 gezeigten Typ zusammengesetzt ist. Die Anordnung der zwei Aufwärts-Umsetzer ist spiegelsymmetrisch, ihre Komponenten haben in Fig. 2 die gleichen Bezugszeichen wie in Fig. 1, wobei die des zweiten Mischers in Fig. 2 jeweils durch ein Apostroph (') gekennzeichnet sind. Das dem zweiten Mischer zugeführte Zwischenfrequenzsignal IF' ist gegenüber dem Zwischenfrequenzsignal IF um 90° phasenverschoben. Dies führt dazu, dass am Ausgang HF' des zweiten Aufwärts-Mischers eines der zwei Seitenbänder phasengleich zum vom ersten Umsetzer gelieferten Signal, das andere Seitenband aber gegenphasig vorliegt. Die Ausgangssignale der zwei Aufwärts-Umsetzer werden in einem Lange-Koppler LC überlagert, von dessen zwei Ausgängen dann einer das obere Seitenband (USB), der andere das untere (LSB) liefert.

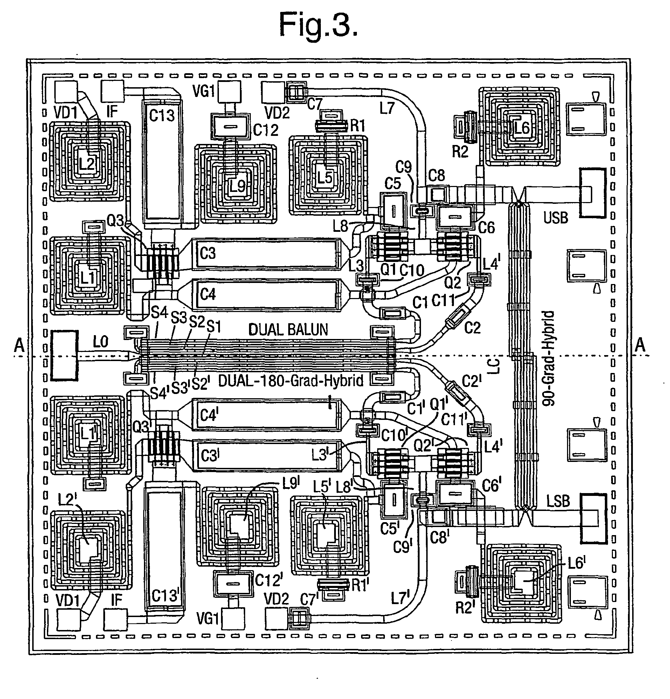

Fig. 3 zeigt schematisch die Anordnung der diversen Komponenten des Einseitenband-Mischers aus Fig. 2 auf einem Substrat. Die zwei Aufwärts-Mischer sind spiegelsymmetrisch beiderseits einer strichpunktierten Mittellinie A-A angeordnet. Entlang dieser Mittellinie A-A erstreckt sich ein zweifaches Symmetrierglied, das sieben parallele Mikrostreifenleiterabschnitte S1, S2, S3, S4, S2', S3', S4' umfasst. Ein mittlerer dieser Abschnitte S1 ist an einem seiner Enden mit einem Anschlusspad für das Lokaloszillatorsignal LO verbunden, das andere, von dem LO-Anschlusspad abgewandte Ende ist auf Masse gelegt. Von diesem mittleren Mikrostreifenleiter S1 nach außen sind der Reihe nach angeordnet: ein erster Mikrostreifenleiter S2, S2', der an einem dem Lokaloszillator-Anschlusspad LO zugewandten Ende mit Masse verbunden ist und an einem gegenüberliegenden Ende über den Kondensator C2 bzw. C2' mit dem HEMT Q2 bzw. Q2' verbunden ist, ein zweiter Mikrostreifenleiter S3, S3', der an seinem dem Lokaloszillator-Anschlusspad LO zugewandten Ende mit dem entsprechenden Ende des Mikrostreifenleiters S1 verbunden ist und an seinem abgewandten Ende wie der Mikrostreifenleiter S1 auf Masse gelegt ist, sowie ein dritter Mikrostreifenleiter S4, S4', der an seinem dem Lokaloszillator-Pad LO zugewandten Ende mit S1, S3, S3' verbunden und an seinem gegenüberliegenden Ende über den Kondensator C1 bzw. C1' mit dem HEMT Q1 bzw. Q1' verbunden ist.

Das doppelte Symmetrierglied fungiert so gleichzeitig als Leistungsteiler, der das Lokaloszillatorsignal LO mit gleicher Leistung den zwei Aufwärts-Frequenzumsetzern beiderseits der Mittellinie A-A zuführt.

## Patentansprüche

1. Aufwärts-Frequenzumsetzer mit einem Substrat, auf dem integriert sind:
ein erster und ein zweiter Eingang für zwei zu mischende Eingangssignale (IF, LO) wobei das erste Eingangssignal (IF) eine niedrigere Frequenz als das zweite Eingangssignal (LO) hat,
ein erstes und ein zweites Steuerelement (Q1, Q2), jeweils mit einem Steueranschluss (G) und zwei Hauptanschlüssen (S,D), wobei der Stromfluss zwischen den Hauptanschlüssen durch ein am Steueranschluss anliegendes Signal steuerbar ist, und
ein Ausgang (HF) für ein aus den zwei zu mischenden Eingangssignalen erzeugtes gemischtes Signal,
wobei die Steueranschlüsse der zwei Steuerelemente (Q1, Q2) im Gegentakt mit dem zweiten Eingangssignal (LO) beschaltet sind, und die ersten Hauptanschlüsse der zwei steuerelemente (Q1, Q2) miteinander und mit dem Ausgang (HF) verbunden sind,
**gekennzeichnet durch** ein auf dem Substrat integriertes erstes Symmetrierglied (Q3), das den Eingang für das erste Eingangssignal (IF) mit den zweiten Hauptanschlüssen der zwei Steuerelemente (Q1, Q2) verbindet.

2. Aufwärts-Frequenzumsetzer nach Anspruch 1, **dadurch gekennzeichnet, dass** das erste Symmetrierglied ein drittes Steuerelement (Q3) ist, dessen Steueranschluss mit dem ersten Eingangssignal (IF) beschaltet ist und von dessen zwei Hauptanschlüssen jeder mit einem von zwei Versorgungspotentialen (VD1, GND) und mit einem Anschluss des ersten bzw. des zweiten Steuerelementes (Q1, Q2) verbunden ist.

3. Aufwärts-Frequenzumsetzer nach Anspruch 2, **dadurch gekennzeichnet, dass** jeder Hauptanschluss des dritten Steuerelementes mit einem zweiten Hauptanschluss des ersten bzw. des zweiten Steuerelementes (Q1, Q2) verbunden ist.

4. Aufwärts-Frequenzumsetzer nach einem der vorhergehenden Ansprüche, **dadurch gekennzeichnet, dass** die Steuerelemente Transistoren sind.

5. Aufwärts-Frequenzumsetzer nach einem Anspruch 4, **dadurch gekennzeichnet, dass** die Transistoren HEMTs sind.

6. Aufwärts-Frequenzumsetzer nach Anspruch 4 oder 5, **dadurch gekennzeichnet, dass** das dritte Steuerelement (Q3) in seinem linearen Bereich arbeitet.

7. Aufwärts-Frequenzumsetzer nach einem der Ansprüche 4 bis 6, **dadurch gekennzeichnet, dass** das erste und das zweite Steuerelement (Q1, Q2) in die Nähe ihres Pinch-Off-Bereiches vorgespannt betrieben sind.

8. Aufwärts-Frequenzumsetzer nach Anspruch 7, **dadurch gekennzeichnet, dass** das erste und das zweite Steuerelement (Q1, Q2) durch automatische Arbeitspunkteinstellung (self bias) vorgespannt sind.

9. Aufwärts-Frequenzumsetzer nach einem der vorhergehenden Ansprüche, **gekennzeichnet durch** ein zweites Symmetrierglied (S1, S2, S3, S4; S1, S2, S3, S4, S2', S3', S4'), das eingangsseitig mit dem Eingang für das zweite Eingangssignal (LO) und ausgangsseitig mit den Steuereingängen des ersten und des zweiten Steuerelements (Q1, Q2) verbunden ist.

10. Einseitenband-Frequenzumsetzer mit zwei Aufwärts-Frequenzumsetzern nach einem der vorhergehenden Ansprüche, **dadurch gekennzeichnet, dass** die Ausgänge beider Aufwärts-Frequenzumsetzer an Eingänge eines Lange-Kopplers (LC) angeschlossen sind, von dem ein Ausgang einen Ausgang des Einseitenband-Frequenzumsetzers bildet.

11. Einseitenband-Frequenzumsetzer mit zwei Aufwärts-Frequenzumsetzern nach Anspruch 9, **dadurch gekennzeichnet, dass** das zweite Symmetrierglied (S1, S2, S3, S4, S1', S2', S3') gleichzeitig als Leistungsteiler ausgebildet ist.

12. Einseitenband-Frequenzumsetzer nach Anspruch 11, **dadurch gekennzeichnet, dass** das zweite Symmetrierglied einen mittigen, mit einem Signaleingang des Einseitenband-Frequenzumsetzers verbundenen ersten Leiterabschnitt (S1) und beiderseits des ersten Leiterabschnitts (S1) eine Mehrzahl von zweiten Leiterabschnitten (S2 , S3, S4, S2' , S3', S4') aufweist, wobei die Steuereingänge des ersten und zweiten Steuerelements (Q1, Q2) des ersten Aufwärts-Frequenzumsetzers mit zweiten Leiterabschnitten (S2, S4) auf der einen Seite des mittigen Leiterabschnitts verbunden sind und die Steuereingänge des ersten und zweiten Steuerelements (Q1', Q2') des zweiten Aufwärts-Frequenzumsetzers mit zweiten Leiterabschnitten (S2', S4') auf der anderen Seite des mittigen Leiterabschnitts (S1) verbunden sind.

13. Einseitenband-Frequenzumsetzer nach Anspruch 12, **dadurch gekennzeichnet, dass** die Leiterabschnitte (S1, S2, S3, S4, S2', S3', S4') in einer gemeinsamen Ebene angeordnete Mikrostreifenleiterabschnitte sind.

14. Einseitenband-Frequenzumsetzer nach Anspruch 12 oder 13, **dadurch gekennzeichnet, dass** die Leiterabschnitte (S1, S2, S3, S4, S2', S3', S4') parallel und äquidistant sind.

15. Einseitenband-Frequenzumsetzer nach einem der Ansprüche 12 bis 14, **dadurch gekennzeichnet, dass** das zweite Symmetrierglied je drei nebeneinanderliegende Leiterabschnitte (S2, S3, S4; S2', S3', S4') beiderseits des mittigen Leiterabschnitts (S1) aufweist, und dass von den drei nebeneinanderliegenden Leiterabschnitten jeweils ein mittlerer (S3, S3') an seinen beiden Enden mit dem mittigen Leiterabschnitt (S1) verbunden ist.

## Claims

1. A step-up frequency converter comprising a substrate on which there are integrated:
a first and a second input for two input signals (IF, LO) to be mixed, wherein the first input signal (IF) has a lower frequency than the second input signal (LO);
a first and a second control element (Q1, Q2), each with a control connection (G) and two main connections (S, D), wherein the current flow between the main connections can be controlled by a signal applied to the control connection; and
an output (HF) for a mixed signal generated from the two input signals to be mixed;
wherein the control connections of the two control elements (Q 1, Q2) are connected in push-pull to the second input signal (LO) and
the first main connections of the two control elements (Q1, Q2) are connected to one another and to the output (HF);
**characterised by** a first balun (Q3) which is integrated on the substrate and which connects the input for the first input signal (IF) to the second main connections of the two control elements (Q 1, Q2).

2. A step-up frequency converter in accordance with claim 1, **characterised in that** the first balun is a third control element (Q3) whose control connection is connected to the first input signal (IF) and each of whose two main connections is connected to one of two power supply potentials (VD, GND) and to a connection of the first or second control elements (Q1, Q2).

3. A step-up frequency converter in accordance with claim 2, **characterised in that** each main connection of the third control element is connected to a second main connection of the first or second control elements (Q1, Q2).

4. A step-up frequency converter in accordance with any one of the preceding claims, **characterised in that** the control elements are transistors.

5. A step-up frequency converter in accordance with claim 4, **characterised in that** the transistors are HEMTs

6. A step-up frequency converter in accordance with claim 4 or claim 5, **characterised in that** the third control element (Q2) operates in its linear range.

7. A step-up frequency converter in accordance with any one of the claims 4 to 6, **characterised in that** the first and the second control elements (Q1, Q2) are operated with bias in the vicinity of their pinch-off region.

8. A step-up frequency converter in accordance with claim 7, **characterised in** the first and the second control elements (Q1, Q2) are biased by automatic setting of the working point (self-bias).

9. A step-up frequency converter in accordance with any one of the preceding claims, **characterised by** a second balun (S1, S2, S3, S4; S1, S2, S3, S4, S2', S3', S4') which is connected on an input side to the input for the second input signal (LO) and on an output side to the control inputs of the first and second control elements (Q1, Q2).

10. A single sideband frequency converter comprising two step-up frequency converters in accordance with any one of the preceding claims, **characterised in that** the outputs of both step-up frequency converters are connected to inputs of a Lange coupler (LC), one output of which forms an output of the single sideband frequency converter.

11. A single sideband frequency converter comprising two step-up frequency converters in accordance with claim 9, **characterised in that** the second balun (S1, S2, S3, S4, S1', S2', S3') is simultaneously designed as a power divider.

12. A single sideband frequency converter in accordance with claim 11, **characterised in that** the second balun has a central first conductor section (S1) connected to a signal input of the single sideband frequency converter and has, on both sides of the first conductor section (S1), a plurality of second conductor sections (S2, S3, S4, S2', S3', S4'), with the control inputs of the first and second control elements (Q1, Q2) of the first step-up frequency converter being connected to second conductor sections (S2, S4) on the one side of the central conductor section, and with the control inputs of the first and second control elements (Q1, Q2) of the second step-up frequency converter being connected to second conductor sections (S2', S4') on the other side of the central conductor section (S1).

13. A single sideband frequency converter in accordance with claim 12, **characterised in that** the conductor sections (S1, S2, S3, S4, S2', S3', S4') are microstrip conductor sections arranged in a common plane

14. A single sideband frequency converter in accordance with claim 12 or claim 13, **characterised in that** the conductor sections (S1, S2, S3, S4, S2', S3', S4') are parallel and equidistant.

15. A single sideband frequency converter in accordance with any one of the claims 12 to 14, **characterised in that** the second balun has three respective adjacent conductor sections (S2, S3, S4; S2', S3', S4') on both sides of the central conductor section (S1), and **in that** a respective central one (S3, S3') of the three adjacent conductor sections is connected at both its ends to the central conductor section (S1).

## Revendications

1. Convertisseur de fréquences vers le haut, comprenant un substrat sur lequel sont intégrés les éléments suivants :
une première et une seconde entrée pour deux signaux d'entrée (IF, LO) à mélanger, le premier signal d'entrée (IF) ayant une fréquence plus basse que le second signal d'entrée (LO),
un premier et un second élément de commande (Q1, Q2), comprenant chacun un raccord de commande (G) et deux raccords principaux (S, D), tels que l'écoulement de courant entre les raccords principaux peut être commandé par un signal appliqué au raccord de commande, et
une sortie (HF) pour un signal mélangé engendré à partir des deux signaux d'entrée à mélanger,
dans lequel les raccords de commande des deux éléments de commande (Q1, Q2) sont branchés en opposition au second signal d'entrée (LO), et les premiers raccords principaux des deux éléments de commande (Q1, Q2) sont reliés l'un à l'autre et à la sortie (HF),
**caractérisé par** un premier circuit de symétrisation (Q3) intégré sur le substrat, qui relie l'entrée pour le premier signal d'entrée (IF) aux seconds raccords principaux des deux éléments de commande (Q1, Q2).

2. Convertisseur de fréquences vers le haut selon la revendication 1, **caractérisé en ce que** le premier circuit de symétrisation est un troisième élément de commande (Q3), dont le raccord de commande est branché avec le premier signal d'entrée (IF), et dont les deux raccords principaux sont reliés chacun à un potentiel d'alimentation (VD1, GND) parmi deux, et à un raccord du premier ou du second élément de commande (Q1, Q2).

3. Convertisseur de fréquences vers le haut selon la revendication 2, **caractérisé en ce que** chaque raccord principal du troisième élément de commande est relié à un second raccord principal du premier ou du second élément de commande (Q1, Q2).

4. Convertisseur de fréquences vers le haut selon l'une des revendications précédentes, **caractérisé en ce que** les éléments de commande sont des transistors.

5. Convertisseur de fréquences vers le haut selon la revendication 4, **caractérisé en ce que** les transistors sont des transistors HEMT.

6. Convertisseur de fréquences vers le haut selon la revendication 4 ou 5, **caractérisé en ce que** le troisième élément de commande (Q3) fonctionne dans son domaine linéaire.

7. Convertisseur de fréquences vers le haut selon l'une des revendications 4 à 6, **caractérisé en ce que** le premier et le second élément de commande (Q1, Q2) sont amenés en fonctionner sous une tension renforcée au voisinage de leur plage de "Pinch-Off'.

8. Convertisseur de fréquences vers le haut selon la revendication 7, **caractérisé en ce que** le premier et le second élément de commande (Q1, Q2) sont mis sous une tension renforcée par réglage automatique du point de travail ("self bias").

9. Convertisseur de fréquences vers le haut selon l'une des revendications précédentes, **caractérisé par** un second circuit de symétrisation (S1, S2, S3, S4 ; S1, S2, S3, S4, S2', S3', S4'), qui est relié du côté entrée à l'entrée pour le second signal d'entrée (LO) et du côté sortie aux entrées de commande du premier et du second élément de commande (Q1, Q2).

10. Convertisseur de fréquences à bande latérale unique, comprenant deux convertisseurs de fréquences vers le haut selon l'une des revendications précédentes, **caractérisé en ce que** les sorties des deux convertisseurs de fréquence vers le haut sont raccordées à des entrées d'un coupleur de Lange (LC), une sortie de celui-ci formant une sortie du convertisseur de fréquences à bande latérale unique.

11. Convertisseur de fréquences à bande latérale unique comprenant deux convertisseurs de fréquence vers le haut selon la revendication 9, **caractérisé en ce que** le second circuit de symétrisation (S1, S2, S3, S4, S1', S2', S3') est réalisé simultanément à la manière d'un diviseur de puissance.

12. Convertisseur de fréquences à bande latérale unique selon la revendication 11, **caractérisé en ce que** le second circuit de symétrisation comprend un premier tronçon de conducteur central (S1), relié à une entrée de signal du convertisseur de fréquence à bande latérale unique et, des deux côtés du premier tronçon de conducteur (S1), une pluralité de seconds tronçons de conducteurs (S2, S3, S4, S2', S3', S4'), tels que les entrées de commande du premier et du second élément de commande (Q1, Q2) du premier convertisseur de fréquence vers le haut sont reliées à des seconds tronçons de conducteurs (S2, S4) sur un côté du tronçon de conducteur central, et les entrées de commande du premier et du second élément de commande (Q1', Q2') du second convertisseur de fréquences vers le haut sont reliées à des seconds tronçons de conducteurs (S2', S4') sur l'autre côté du tronçon de conducteur central (S1).

13. Convertisseur de fréquences à bande latérale unique selon la revendication 12, **caractérisé en ce que** les tronçons de conducteurs (S1, S2, S3, S4, S2', S3', S4') sont des tronçons de conducteurs à microbandes agencés dans un plan commun.

14. Convertisseur de fréquences à bande latérale unique selon la revendication 12 ou 13, **caractérisé en ce que** les tronçons de conducteurs (S1, S2, S3, S4, S2', S3', S4') sont parallèles et équidistants.

15. Convertisseur de fréquences à bande latérale unique selon l'une des revendications 12 à 14, **caractérisé en ce que** le second circuit de symétrisation comprend trois tronçons de conducteurs situés les uns à côté des autres (S2, S3, S4 ; S2', S3', S4') des deux côtés du tronçon de conducteur central (S1), et **en ce que**, parmi les trois tronçons de conducteurs situés les uns à côté des autres, un tronçon médian respectif (S3, S3') est relié à ses deux extrémités avec le tronçon de conducteur central (S1).
